Europäisches Patentamt

European Patent Office

Office européen des brevets

(19)

(11) Veröffentlichungsnummer : **0 013 728**
**B1**

(12) **EUROPÄISCHE PATENTSCHRIFT**

(45) Veröffentlichungstag der Patentschrift :
21.03.84

(51) Int. Cl.³ : **H 01 L 21/90, H 01 L 23/52,
H 05 K 3/00**

(21) Anmeldenummer : 79105056.0

(22) Anmeldetag : 10.12.79

(54) Verfahren zur Herstellung von elektrischen Verbindungen zwischen Leiterschichten in Halbleiterstrukturen.

(30) Priorität : 29.12.78 US 974572

(43) Veröffentlichungstag der Anmeldung :
06.08.80 Patentblatt 80/16

(45) Bekanntmachung des Hinweises auf die Patenterteilung : 21.03.84 Patentblatt 84/12

(84) Benannte Vertragsstaaten :
DE FR GB

(56) Entgegenhaltungen :
DE-A- 2 709 933
DE-B- 2 061 382
FR-A- 2 349 957
IBM TECHNICAL DISCLOSURE BULLETIN, Band 21, Nr. 7, Dezember 1978 New York R. CULLET "Process for interconnecting different levels of metal in an integrated circuit" Seiten 2850 bis 2851

(73) Patentinhaber : **International Business Machines Corporation**
**Old Orchard Road**
**Armonk, N.Y. 10504 (US)**

(72) Erfinder : **Dalal, Hormazdyar Minocher**
**66 Amherst Lane**
**Wappingers Falls, N.Y. 12590 (US)**
Erfinder : **Patnaik, Bisweswar**
**8 Strawberry Hill**
**Wappingers Falls, N.Y. 12590 (US)**
Erfinder : **Sarkary, Homi Gustadji**
**29 Verplank Ave**
**Hopewell Junction, N.Y. 12533 (US)**

(74) Vertreter : **Oechssler, Dietrich, Dr.rer.nat. Dipl.-Chem.**
**Schönaicher Strasse 220**
**D-7030 Böblingen (DE)**

# Verfahren zur Herstellung von elektrischen Verbindungen zwischen Leiterschichten in Halbleiterstrukturen

Die Erfindung betrifft ein Verfahren zur Herstellung von elektrischen Verbindungen zwischen Leiterschichten, die in verschiedenen Ebenen einer Halbleiterstruktur die Leitungen der Schaltkreise bilden, bei dem auf einer strukturierten Leiterschicht einer ersten unteren Ebene, die auf einer das Halbleitersubstrat bedeckenden Deckschicht aufgebracht ist, die elektrischen Verbindungen unter Verwendung einer aus mindestens zwei Schichten bestehenden Maske erzeugt werden, bei dem die so gewonnene Struktur ganzflächig mit einer Isolierschicht bedeckt wird, bei dem anschließend die Oberseite der Verbindungen freigelegt und schließlich ganzflächig die Metallschicht, aus welcher die noch zu erzeugende Leiterschicht der zweiten Ebene teilweise besteht, aufgebracht wird.

Aus der DE-OS 27 09 933 ist ein Verfahren zum Herstellen von elektrischen Verbindungen zwischen mehreren Leiterebenen bekannt. Dabei wird nach dem Herstellen der ersten auf einem Substrat aufgebrachten Leiterebene auf Teilen der ersten Leiterebene ein Muster aus einem ersten Metall mittels einer Maske aus einem verbrauchbaren, auf dem ersten Metall aufliegenden Material erzeugt, wobei das verbrauchbare Material durch ein Ätzmittel entfernt werden kann, das weder das Metall noch das erste Leitungsmuster und das Substrat angreift. Anschließend wird eine isolierende Schicht mittels Hochfrequenzkathodenzerstäubung ganzflächig niedergeschlagen, wobei bei einer so hohen Vorspannung gearbeitet wird, daß eine wesentliche Re-Emmision des Isoliermaterials stattfindet. Dadurch werden die freiliegenden Oberflächen des Substrats, der ersten Leiterebene und des Musters mit dem Isoliermaterial überzogen, während die Seitenflächen des verbrauchbaren Materials frei bleiben. Schließlich wird das verbrauchbare Material abgeätzt und dann eine Metallschicht zur Erzeugung der zweiten Leiterebene aufgebracht.

Bei diesem bekannten Verfahren ergibt sich der Nachteil, daß zwischen der Oberfläche der ersten Leiterebene und dem in den Durchgangsöffnungen der Isolierschicht befindlichen Metall eine ausreichende Festigkeit der Verbindung nicht hergestellt werden kann. Daraus ergeben sich Kontaktwiderstände, welche die Qualität des Halbleiterprodukts beeinträchtigen.

Ein ähnliches Verfahren zur Erzeugung von Leiterstrukturen mit übereinanderliegenden und untereinander verbundenen Leiterebenen ist in dem Artikel « Process for Interconnecting Different Levels of Metal in an integrated Circuit » von R. Cullet beschrieben, welcher im IBM Technical Disclosure Bulletin, Bd. 21, Nr. 7, Dezember 1978, Seite 2850 veröffentlicht ist. Bei dem dort beschriebenen Verfahren wird die Isolierschicht zur Trennung zweier Leiterebenen auch erst aufgebracht, nachdem auf der ersten Leiterebene Metallbereiche zum Verbinden zweier Leiterebenen erzeugt worden sind. Anschließend wird die Isolierschicht unter Freilegung der Metallbereiche planarisiert und dann das Metall für die zweite Leiterebene aufgebracht. Auch bei diesem Verfahren treten wie bei dem oben beschriebenen Verfahren Probleme mit den Kontaktwiderständen auf.

Es ist die Aufgabe der vorliegenden Erfindung, bei der Herstellung von Halbleiterstrukturen die elektrischen Verbindungen zwischen Leiterschichten verschiedener Ebenen so herzustellen, daß eine hohe Qualität bezüglich der mechanischen und elektrischen Eigenschaften erzielt wird.

Die genannte Aufgabe wird bei einem Verfahren gemäß dem Oberbetriff des Anspruchs 1 durch die in dessen Kennzeichen genannten Merkmale gelöst. Das Verfahren ermöglicht die Herstellung von Verbindungen in Halbleiterstrukturen, welche eine Verdichtung der Schaltkreise ermöglicht. Daraus ergibt sich eine Ermäßigung der Herstellungskosten und eine Erweiterung der Anwendungsmöglichkeiten von Halbleitern.

Die Erfindung wird anhand eines Ausführungsbeispiels näher erläutert.

Es zeigen :

Figur 1 die Teile einer Halbleiterstruktur in Querschnittsdarstellung,

Figuren 2A bis 2K die in aufeinanderfolgenden Verfahrensschritten erzeugten Teile einer Halbleiterstruktur in Querschnittsdarstellung,

Figur 3 die photographische Aufnahme der Oberfläche einer Halbleiterstruktur nach Herstellung der Leiterschicht der etsten Ebene mit an der Schichtoberfläche hervortretenden Einzelbereichen einer Zwischenmetallschicht.

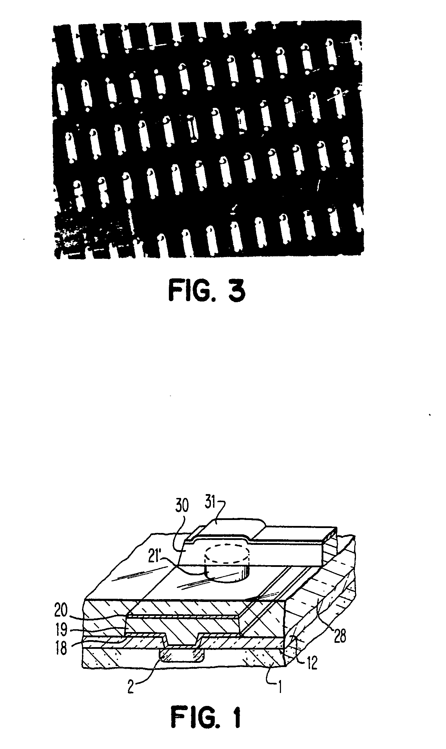

Die in Fig. 1 dargestellte Metallschicht 19 der ersten Ebene ist durch die dielektrische Schicht 12 von dem eine Dotierung aufweisenden Bereich 2 des Halbleitersubstrats 1 getrennt. Eine metallene Unterlage 18, die eine geringere Ätzgeschwindigkeit aufweist als die Metallschicht 19, ist zwischen dem dotierten Bereich 2 und der Metallschicht 19 der ersten Ebene angeordnet. Wenn z. B. die Metallschicht 19 aus einer Aluminium/Kupfer-Legierung besteht, wird als Material für die metallene Unterlage 18, die eine niedrige Ätzgeschwindigkeit aufweist und somit als Ätzsperre wirkt, Chrom verwendet. Dieses Material verhindert eine Wechselwirkung zwischen dem Aluminium der Metallschicht 19 mit einem Kontaktmaterial des dotierten Bereiches 2, das normalerweise aus einem Platinsilizid besteht.

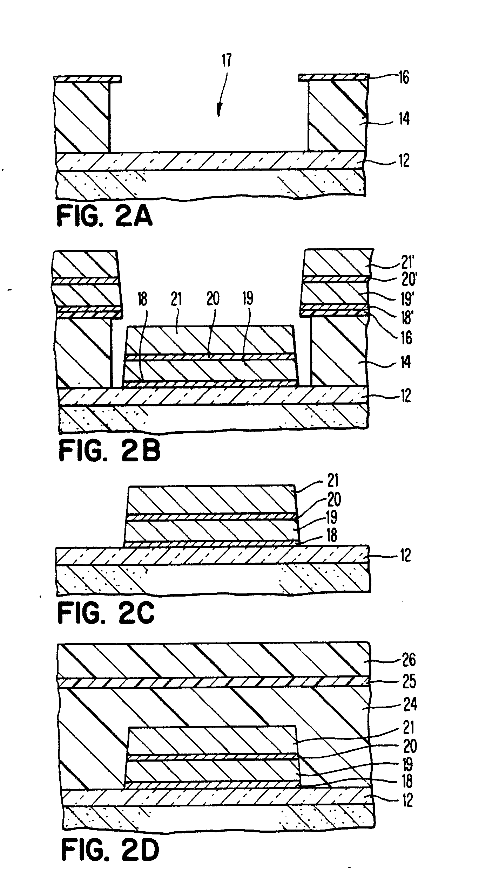

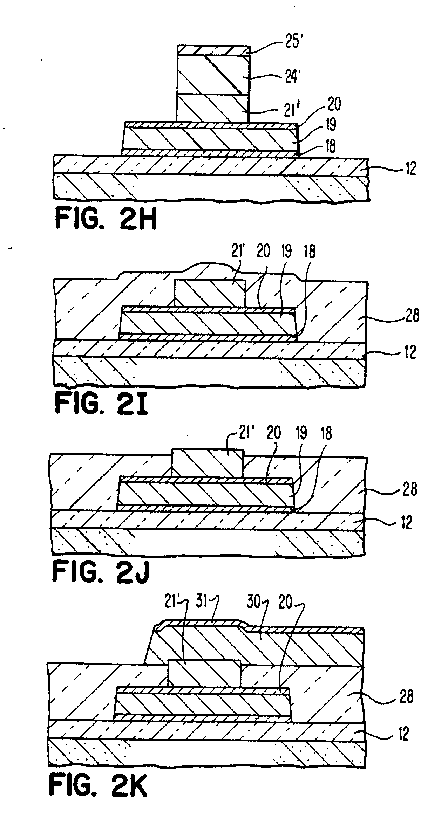

Die Leiterschicht der ersten Ebene ist ein Teil eines ausgedehnten Leitungsmusters an der Oberfläche des Halbleitersubstrats 1, das mit einer Leiterschicht einer zweiten Ebene sowie mit anderen nicht dargestellten Leiterzügen der ersten Leiterebene verbunden ist. An der Oberfläche der Leiterschicht der ersten Ebene aus einer Zwischenmetallschicht gebildete, erhöhte Einzelbereiche 21' verbinden die Leiterschicht der ersten Ebene durch eine dielektrische Isolierschicht 28 hindurch mit der Metallschicht 30 einer zweiten Ebene, welche die untere Schicht der Leiterschicht der zweiten Ebene bildet. Die dielektrische Isolierschicht 28 wird vorzugsweise durch das Kathodenzerstäuben von Siliciumdioxid gebildet. Über der Metallschicht 19 der ersten Ebene ist die metallene Ätzsperre 20 angeordnet, die eine niedrigere Ätzgeschwindigkeit aufweist als die Metallschicht 19 und deshalb eine Ätzsperre für die darunter befindliche Metallschicht 19 bildet, wenn aus einer Zwischenmetallschicht durch Ätzen die hervortretenden den Einzelbereiche 21' gebildet werden, die in der Halbleiterstruktur als Verbindungen zu der Metallschicht 30 der zweiten Ebene angeordnet. Sie hat eine niedrigere Ätzgeschwindigkeit als das Material der Metallschicht 30 und dient somit als eine Ätzsperre. Über der Ätzsperre 31 kann eine Zwischenmetallschicht mit hervortretenden Einzelbereichen gebildet werden, welche durch eine nicht dargestellte dielektrische Schicht hindurch die Leiterschicht der zweiten Ebene mit einer nicht dargestellten Leiterschicht einer dritten Ebene verbinden. Der dazu erforderliche Herstellungsvorgang entspricht dem anhand der Fign. 2A bis 2K beschriebenen Verfahren für die Herstellung von Verbindungen zwischen den Leiterschichten der ersten und zweiten Ebene.

Ein aus einem Halbleitersubstrat 1 gebildetes Halbleiterchip enthält eine große Anzahl von dotierten Bereichen 2. Die beschriebenen Leiterschichten der ersten, zweiten und dritten Ebene dienen dazu, diese dotierten Bereiche untereinander zu Schaltkreisen und außerdem diese Schaltkreise mit Stromversorgungsleitungen zu verbinden.

Die Fign. 2A und 2B zeigen die Herstellung der Metallschicht 19 der ersten Ebene, deren Flächenmuster auf die dielektrische Schicht 12 an der Oberfläche eines Halbleitersubstrats aufgetragen wird. Diese Herstellung ergibt sich nach einem bekannten Verfahren (US-PS 4 004 044).

Andere Herstellungsmöglichkeiten ergeben sich nach bekannten Verfahren durch Ionenätzen.

Gemäß der Darstellung nach Fig. 2A wird zunächst an der Oberfläche der dielektrischen Deckschicht 12 eine nicht dargestellte dünne Schicht von Polyäthersulfon nach einem bekannten Verfahren aufgetragen (IBM Technical Disclosure Bulletin, Vol. 19, No. 4, September 1976, S. 226). Auf die Schicht von Polyäthersulfon wird sodann eine aus einem organischen Polymer bestehende Schicht 14 aufgetragen, die bei einer Temperatur von 210 °C bis 230 °C gesintert wird, um sie nicht lichtempfindlich zu machen. An der Oberfläche der Schicht 14 wird eine Schicht 16 von Methylsiloxan aufgetragen, die durch eine nicht dargestellte strahlungsempfindliche Schicht bedeckt wird.

Die strahlungsempfindliche Schicht wird in bekannter Weise bestrahlt und entwickelt, um die Abbildung eines Oberflächenmusters zu erzeugen. Daraus ergibt sich eine Maske, mit deren Hilfe an der Halbleiterstruktur die Ausnehmung 17 gebildet wird. An einem Halbleiterchip wird mit Hilfe der Maske eine große Anzahl von nicht näher dargestellten Öffnungen 17 erzeugt. Nach Herstellung der Öffnung 17 wird eine aus Chrom bestehende metallene Unterlage 18 an der Oberfläche der ganzen Halbleiterstruktur aufgetragen. Die Unterlage 18, die eine niedrige Ätzgeschwindigkeit aufweist, dient in nachfolgenden Herstellungsvorgängen als Ätzsperre. Diejenigen Teile, die beim Herstellungsvorgang erhalten bleiben, sind als Unterlage 18 bezeichnet. Diejenigen Teile, die bei nachfolgenden Herstellungsschritten entfallen, sind als Unterlage 18' bezeichnet. In gleicher Weise sind verbleibende und entfallende Schichten verschieden gekennzeichnet.

Wie bereits erwähnt wirkt die metallene Unterlage 18, die aus Chrom bestehen kann, als eine Ätzsperre. Die Anwendung der Unterlage 18 ist für die Durchführung des Verfahrens nicht unbedingt erforderlich. Eine Metallschicht 19, die aus einer Aluminium/Kupfer-Legierung besteht, die durch einen kleinen Betrag von Silicium verunreinigt ist, könnte ohne nachteilige Wirkung für das Verfahren direkt auf der Deckschicht 12 des Halbleitersubstrats aufgetragen werden. Anstelle von Chrom könnte die Unterlage 18 auch aus einer Tantal/Chrom-Legierung oder anderen Metallen wie z. B. Titan, Wolfram oder deren Legierungen bestehen.

Gemäß der Darstellung nach Fig. 2B wird eine Metallschicht 19, die vorzugsweise aus einer Aluminium/Kupfer-Legierung besteht, in einer Verdampfungskammer auf die Unterlage 18 aufgetragen. Aus der Metallschicht 19 besteht teilweise die nachfolgend zu erzeugende Leiterschicht der ersten Ebene.

Auf die Metallschicht 19, die eine höhere Ätzgeschwindigkeit aufweist, wird die metallene Ätzsperre 20 aufgetragen, die eine niedrigere Ätzgeschwindigkeit aufweist. Diese Schicht, die aus Chrom besteht, hat vorzugsweise eine Dicke von ca. 0,1 $\mu$. Sie wirkt in den nachfolgenden Verfahrensschritten als eine Ätzsperre. Auf die Ätzsperre 20 wird sodann die Zwischenmetallschicht 21 aufgetragen. Diese besteht aus einer Aluminium/Kupfer-Legierung. Sie hat den Zweck, zwischen den Leiterschichten verschiedener Ebenen elektrische Verbindungen herzustellen.

Bei dem vorliegenden Verfahren beträgt die Dicke der strahlungsempfindlichen Schicht 14 ungefähr das 1,5 fache der Dicke der Schichten 18 bis 21. Es ergeben sich die folgenden Werte : Unterlage 18 0,1 $\mu m$, Metallschicht 19 ca. 0,85 $\mu m$, Ätzsperre 20 0,1 $\mu m$, Zwischenmetallschicht 21 1,55 $\mu m$.

Durch eine Lösung von N-Methylpyrrolidon werden die oberen Teile der Struktur entfernt, so daß gemäß der Darstellung nach Fig. 2C die Deckschicht 12 und die mittleren Teile der Anordnung übrigbleiben. Als Material für die Ätzsperre 20 kann anstelle von Chrom auch Tantal, Titan, Wolfram oder deren Legierungen verwendet werden.

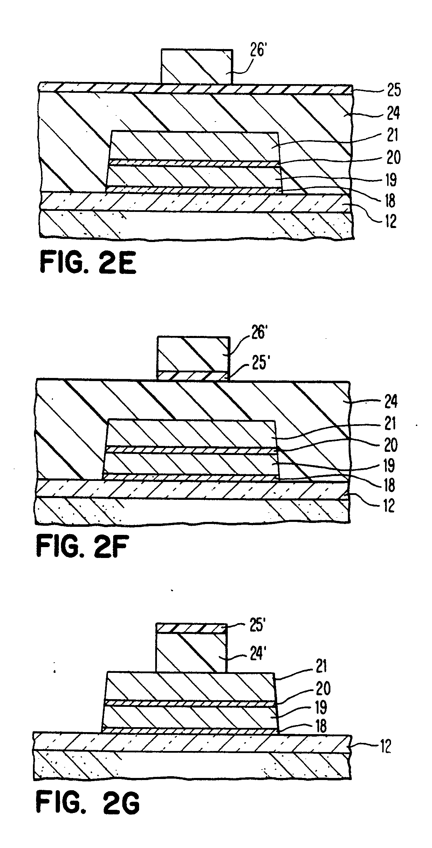

In den folgenden, anhand der Fign. 2D, 2E und 2F dargestellten Verfahrensschritte werden Teile der Zwischenmetallschicht 21 durch die Anwendung von Photomasken im Ätzverfahren abgetragen, um Verbindungen von bestimmten Bereichen der Leiterschicht der ersten Ebene zu bestimmten Bereichen der später herzustellenden Leiterschicht der darüberliegenden zweiten Ebene zu bilden.

Gemäß der Darstellung nach Fig. 2D wird die ganze Oberfläche der Struktur durch eine Schicht 24, die aus einem gesinterten organischen Polymer besteht, bedeckt. An der Oberfläche dieser Schicht wird die Maskenschicht 25 aufgetragen, die aus einem Methylsiloxan-Harz besteht. Diese Schicht wird bedeckt durch die strahlungsempfindliche Schicht 26.

Die Schicht 26 wird belichtet und entwickelt, um gemäß der Darstellung nach Fig. 2E ein Schichtmuster 26' zu erzeugen. Das Schichtmuster entspricht dem Muster der Einzelbereiche, welche aus der Zwischenmetallschicht 21 erzeugt werden sollen, welche die elektrischen Verbindungen zwischen den Leiterschichten von zwei Ebenen herstellen. Die aus Harz bestehende Maskenschicht 25 wird sodann selektiv mittels reaktiven Ionenätzens in bekannter Weise (USP 4 004 044) entfernt, wobei das Schichtmuster 26' als Maske dient.

Das in die Schicht 25 geätzte Muster 25' dient dann als Maske, um die aus einem Polymer bestehende Schicht 24 selektiv mittels reaktiven Ionenätzens in einem Sauerstoff enthaltenden Gasmedium zu entfernen. Durch eine Lösung oder das im Verfahren gebildete Sauerstoffplasma wird das Schichtmuster 26' entfernt. Entsprechend der Darstellung nach Fig. 2G entsteht eine Struktur, in welcher das lichtempfindliche Schichtmuster 24' und das Schichtmuster 25' die Querschnittsform der aus der Zwischenmetallschicht 21 herzustellenden Verbindungen bildet.

Gemäß der Darstellung nach Fig. 2H wird aus der Zwischenmetallschicht 21 das Schichtmuster der erhöhten Einzelbereiche 21' gebildet. Dieser Vorgang erfolgt in einem Plasmamedium oder in einer reaktiven Ionenätzkammer. Wenn das Material der Zwischenmetallschicht 21 aus einer Aluminium/Kupfer-Legierung besteht, wird eine Gasmischung von $Ar/Cl_2$ oder $Ar/CCl_4$ benützt. Die Ätzgeschwindigkeit der Zwischenmetallschicht 21 ist ca. zweimal größer als die Ätzgeschwindigkeit des lichtempfindlichen Schichtmuster 24'. Die darunterliegende Ätzsperre 20 verhindert infolge des großen Unterschiedes, der zwischen den Ätzgeschwindigkeiten von Aluminium und Chrom besteht, das Ätzen der Metallschicht 19. Die Ätzgeschwindigkeit der Aluminium/Kupfer-Legierung beträgt im genannten Gasmedium ungefähr 0,1 μm je Minute, im Gegensatz zur Ätzgeschwindigkeit von Chrom, die ca. 0,01 μm je Minute beträgt. Nach diesem Vorgang werden die verbleibenden Schichtmuster 24' und 25' durch eine in der Ätzkammer befindliche Gasmischung von $CF_4$ und $O_2$ abgetragen, welche weder das Chrom der Ätzsperre 20 noch die Aluminium/Kupfer-Legierung des Schichtmusters der erhöhten Einzelbereiche 21' unterhalb des Schichtmuster 24' wesentlich angreift. Die Schichtmuster 24' und 25' können teilweise auch durch das Eintauchen in eine Lösung entfernt werden, die z. B. aus N-Methylpyrrolidon und einem Photoschichtlöser besteht.

Die freiliegende Metallstruktur wird sodann gemäß der Darstellung nach Fig. 2E durch eine Schicht aus dielektrischem Material 28 bedeckt. Das Auftragen dieser Schicht erfolgt in bekannter Weise (US-PS 3 804 728, 3 983 022) durch Kathodenzerstäuben. Die aus Quartz bestehende dielektrische Schicht 28 wird sodann abgetragen, bis die Oberflächen die Einzelbereiche 21' der Zwischenmetallschicht 21 freiliegen. Das Abtragen der Schicht 28 erfolgt beispielsweise durch beschleunigte Ionen, die bei einer Spannung von 1 000 Volt in einem Winkel von 30 bis 60° auf das sich drehende Substrat gelenkt werden.

Gemäß der Darstellung nach Fig. 2K wird anschließend die Metallschicht 30 der zweiten Ebene an der Oberfläche der Isolierschicht 28 aufgetragen. Diese Metallschicht, die aus einer Aluminium/Kupfer-Legierung besteht, verbindet sich mit den erhöhten Einzelbereichen 21', wodurch bestimmte Bereiche der Leiterschicht der ersten Ebene mit bestimmten Bereichen der Metallschicht 30 der zweiten Metallebene leitend verbunden werden. Die durch die erhöhten Einzelbereiche 21' aus der Zwischenmetallschicht 21 gebildeten leitenden Verbindungen bewirken eine Kontaktierung einer hohen mechanischen und elektrischen Qualität. Die Oberfläche der Metallschicht 30 der zweiten Ebene wird durch eine Schicht 31 aus Chrom bedeckt, welche als Ätzsperre dient. Über dieser Schicht kann sodann eine Zwischenmetallschicht aufgetragen werden, aus welcher sich gemäß den Herstellungsschritten nach den Fig. 2A bis 2I leitende Verbindungen zu einer nicht dargestellten Metallschicht einer dritten Ebene ergeben.

Fig. 3 zeigt die mikrophotographische Darstellung der Oberfläche der ersten Ebene mit den aus der Zwischenmetallschicht gebildeten erhöhten Einzelbereichen. Die Prüfung umfaßte 2 000 Metallstreifen mit Kontakten, die einen niedrigen Kontaktwiderstand und eine hohe mechanische Festigkeit aufwiesen

**Ansprüche**

1. Verfahren zur Herstellung von elektrischen Verbindungen zwischen Leiterschichten, die in verschiedenen Ebenen einer Halbleiterstruktur die Leitungen der Schaltkreise bilden, bei dem auf einer strukturierten Leiterschicht einer ersten unteren Ebene, die auf einer das Halbleitersubstrat bedeckenden Deckschicht (12) aufgebracht ist, die elektrischen Verbindungen unter Verwendung einer aus mindestens zwei Schichten bestehenden Maske (24, 25) erzeugt werden, bei dem die so gewonnene Struktur ganzflächig mit einer Isolierschicht (28) bedeckt wird, bei dem anschließend die Oberseite der Verbindungen freigelegt und schließlich ganzflächig die Metallschicht (30), aus welcher die noch zu erzeugende Leiterschicht der zweiten Ebene teilweise besteht, aufgebracht wird, dadurch gekennzeichnet, daß auf der das Halbleitersubstrat bedeckenden Deckschicht (12) die Leiterschicht der ersten Ebene, die aus einer Metallschicht (19) und einer metallenen Ätzsperre (20), welche sich langsamer als die Metallschicht (19) ätzen läßt, besteht, ganzflächig aufgebracht wird, daß darauf eine Zwischenmetallschicht (21), welche sich schneller ätzen läßt als die metallene Ätzsperre (20), ebenfalls ganzflächig aufgebracht wird, daß die Metallschicht (19), die metallene Ätzsperre (20) und die Zwischenmetallschicht (21) zusammen entsprechend dem gewünschten Muster der Leiterschicht der ersten Ebene strukturiert werden, daß unter Verwendung der aus mindestens zwei Schichten bestehenden und als Ätzmaske dienenden Maske (24, 25) die Zwischenmetallschicht (21) zur Erzeugung von die elektrischen Verbindungen bildenden Einzelbereichen (21') geätzt wird und daß die Isolierschicht (28), um die Oberfläche der Einzelbereiche (21') der Zwischenmetallschicht (21) freizulegen, abgetragen wird.

2. Verfahren nach Anspruch 1, dadurch gekennzeichnet, daß die Metallschicht (19) der ersten Ebene und die Zwischenmetallschicht (21) aus Aluminium, Aluminium/Kupfer-Legierungen oder Aluminium/Kupfer/Silicium-Legierungen und die metallene Ätzsperre (20) aus Chrom, Tantal, Titan, Wolfram oder deren Legierungen gebildet werden.

3. Verfahren nach Anspruch 1 oder 2, dadurch gekennzeichnet, daß das Ätzen der Zwischenmetallschicht (21) mittels reaktiven Ionenätzens in einem aus Ar und Cl oder Ar und CCl$_4$ bestehenden Gemisch durchgeführt wird.

4. Verfahren nach einem der Ansprüche 1 bis 3, dadurch gekennzeichnet, daß das Abtragen der Isolier-schicht (28) aus dielektrischem Material mittels beschleunigter Ionen erfolgt.

5. Verfahren nach einem der Ansprüche 1 bis 4, dadurch gekennzeichnet, daß die oberste Schicht (25) der Ätzmaske aus Methylsiloxan-Harz erzeugt wird.

6. Verfahren nach einem der Ansprüche 1 bis 5, dadurch gekennzeichnet, daß zur Erzeugung elektrischer Verbindungen zwischen Leiterebenen der zweiten der dritten und zwischen noch darüberliegenden Leiterebenen die Verfahrensschritte ab dem Aufbringen der Metallschicht (19) der ersten Ebene bis zum Abtragen der Isolierschicht (28) aus dielektrischem Material ein- oder mehrmals wiederholt werden.

7. Verfahren nach einem der Ansprüche 1 bis 6, dadurch gekennzeichnet, daß vor dem Aufbringen der Metallschicht (19) auf dem Substrat eine metallene Unterlage (18) ganzflächig niedergeschlagen wird.

8. Verfahren nach einem der Ansprüche 1 bis 7, gekennzeichnet durch seine Verwendung bei der Herstellung der Leiterstruktur zwischen dotierten Bereichen (2) des Halbleitersubstrats (1) und zwischen den Bereichen (2) und nach außen führenden Stromversorgungsleitungen.

## Claims

1. Method of making electric connections between conductive layers representing, on different levels of a semiconductor structure, the lines of the circuits, where on a structured conductive layer of a first lower level applied on a layer (12) covering the semiconductor substrate, the electric connections are established using a mask (24, 25) consisting of a least two layers, where the thus obtained structure is blanket coated with an insulating layer (28), where subsequently the upper side of the connections is exposed, and where finally the metal layer (30) partly representing the still to be produced conductive layer of the second level is blanket deposited, characterized in that on the layer (12) covering the semiconductor substrate the conductive layer of the first level which consists of a metal layer (19) and a metallic etch barrier (20) etchable more slowly than the metal layer (19) is blanket deposited, that thereon an interspaced metal layer (21) etchable more quickly than the metal etch barrier (20) is also blanket deposited, that the metal layer (19), the metallic etch barrier (20) and the interspaced metal layer (21) are structured together in accordance with the respective pattern of the conductive layer of the first level, that using the mask (24,25) consisting of at least two layers and serving as an etch mask the interspaced metal layer (21) is etched to obtain seperate regions (21') representing the electrical connections, and that the insulating layer (28) is removed to expose the surface of the separate regions (21') of the interspaced metal layer (21).

2. Method as claimed in claim 1, characterized in that the metal layer (19) of the first level and the interspaced metal layer (21) are made of aluminum, aluminum-copper alloys, or aluminum-copper-silicon alloys, and the metal etch barrier (20) is made of chromium, tantalum, titanium, tungsten, or alloys thereof.

3. Method as claimed in any one of claims 1 or 2, characterized in that the etching of the interspaced metal layer (21) is effected by means of reactive ion etching in a mixture composed of Ar and Cl, or Ar and CCl$_4$.

4. Method as claimed in any one of claims 1 to 3, characterized in that the insulating layer (28) of dielectric material is lifted off by means of accelerated ions.

5. Method as claimed in any one of claims 1 to 4, characterized in that the top layer (25) of the etch mask is made of methylsiloxane resin.

6. Method as claimed in any one of claims 1 to 5, characterized in that for establishing electric connections between conductive levels of the second and third metal layers, and between conductive levels atop these, the process steps from the depositing of the metal layer (19) of the first level to the lifting-off of the insulating layer (28) of dielectric material are repeated once, or several times.

7. Method as claimed in any one of claims 1 to 6, characterized in that prior to the depositing of the metal layer (19) on the substrate a metal substratum (18) is blanket deposited.

8. Method as claimed in any one of claims 1 to 7, characterized by its use in the production of the conductive structure between doped regions (2) of the semiconductor substrate (1), and between the regions (2) and outward-directed current supply lines.

## Revendications

1. Procédé pour établir des connexions électriques entre des couches conductrices qui forment, à des niveaux différents d'une structure semiconductrice, des lignes de conduction de circuits où des connexions électriques sont formées sur une couche conductrice d'un premier niveau de base de ladite structure, déposée à la surface dudit substrat semiconducteur, au moyen d'un masque comportant au moins deux couches (24, 25), où une couche d'isolation (28) est déposée sur toute la surface de la structure obtenue, où la surface desdites connexions est ensuite exposée, et enfin où il est déposé sur toute ladite surface une couche en métal (30) constituant partiellement la couche à former du second niveau de ladite structure semiconductrice, caractérisé en ce que, la couche conductrice dudit premier niveau, constituée, d'une part, d'une couche métallique (19) et, d'autre part, d'une couche barrière métallique (20) dont l'attaque est plus lente que celle de ladite couche métallique (19), est déposée sur toute la surface de la couche (12) déposée sur la surface dudit substrat semiconducteur, qu'une couche intermédiaire métallique (21) dont l'attaque est plus rapide que celle de la couche barrière métallique (20) est déposée également sur toute ladite surface, que la couche métallique (19), la couche barrière métallique (20) et la couche intermédiaire métallique (21) sont construites ensemble conformément à la configuration souhaitée de la couche conductrice du premier niveau, qu'on utilise ledit masque (24, 25) constitué d'au moins deux couches pour attaquer la couche intermédiaire métallique (21) afin d'obtenir des régions distinctes (21') formant lesdites connexions électriques et, que ladite couche d'isolation (28) est enlevée selon la technique dite de décollement afin de découvrir la surface desdites régions distinctes (21') de la couche intermédiaire métallique.

2. Procédé selon la revendication 1, caractérisé en ce que la couche métallique (19) du premier niveau et la couche intermédiaire métallique (21) sont constituées par de l'aluminium, des alliages aluminium/cuivre ou aluminium/cuivre/silicium, et la couche barrière métallique par du chrome, du tantale, du titane, tungstène ou des alliages de ces métaux.

3. Procédé selon la revendication 1 ou 2, caractérisé en ce que la couche intermédiaire métallique (21) est attaquée au moyen d'ions réactifs d'un mélange de Ar et Cl ou d'un mélange Ar et $CCl_4$.

4. Procédé selon une des revendications 1 à 3, caractérisé en ce que la couche d'isolation (28) composée d'un matériau diélectrique est enlevée selon la technique dite de décollement au moyen d'ions accélérés.

5. Procédé selon une des revendications 1 à 4, caractérisé en ce que la couche de surface (25) dudit masque d'attaque est composée d'une résine méthyl siloxane.

6. Procédé selon une des revendications 1 à 5, caractérisé en ce que, afin de former des connexions électriques entre les niveaux conducteurs des deuxième et troisième couches conductrices et entre les niveaux qui leur seront superposés, les étapes du procédé du dépôt de la couche métallique (19) du premier niveau jusqu'à l'enlèvement de la couche d'isolation (28) en matériau diélectrique sont répétées une ou plusieurs fois.

7. Procédé selon une des revendications 1 à 6, caractérisé en ce que le dépôt de ladite couche métallique (19) sur ledit substrat est précédé par le dépôt global sur toute sa dite surface d'une couche métallique (18).

8. Procédé selon une des revendications 1 à 7, caractérisé en ce qu'il est appliqué pour former la partie conductrice, d'une part, entre des régions dopées (2) du substrat semiconducteur (1) et, d'autre part, entre ces régions (2) et les lignes d'alimentation en courant externes.

FIG. 3

FIG. 1

FIG. 2A

FIG. 2B

FIG. 2C

FIG. 2D

FIG. 2E

FIG. 2F

FIG. 2G

**FIG. 2H**

**FIG. 2I**

**FIG. 2J**

**FIG. 2K**